(19) Europäisches Patentamt
European Patent Office
Office européen des brevets

(11) **EP 2 166 129 A1**

(12) **EUROPEAN PATENT APPLICATION**
published in accordance with Art. 153(4) EPC

(43) Date of publication:
**24.03.2010 Bulletin 2010/12**

(51) Int Cl.:
*C23C 16/20* (2006.01)      *C23C 16/44* (2006.01)

(21) Application number: **06797367.7**

(86) International application number:
**PCT/JP2006/317442**

(22) Date of filing: **04.09.2006**

(87) International publication number:
**WO 2007/032218 (22.03.2007 Gazette 2007/12)**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(30) Priority: **14.09.2005   JP 2005267016**

• **OOBA, Yoshiyuki**
  **Yokohama-shi, Kanagawa, 236-8515 (JP)**
• **SAKAMOTO, Hitoshi**
  **Yokohama-shi, Kanagawa, 236-8515 (JP)**
• **OGURA, Yuzuru**
  **Yokohama-shi, Kanagawa, 236-8515 (JP)**
• **SEKINE, Takayuki**
  **Yokohama-shi, Kanagawa, 236-8515 (JP)**

(71) Applicant: **Canon Anelva Corporation**
**Asao-ku**
**Kawasaki-shi**
**Kanagawa 215-8550 (JP)**

(74) Representative: **Musker, David Charles et al**
**R.G.C. Jenkins & Co**
**26 Caxton Street**
**London SW1H 0RJ (GB)**

(72) Inventors:
• **JUN, Keeyoung**
  **Yokohama-shi, Kanagawa, 236-8515 (JP)**

(54) **THIN-FILM PRODUCING APPARATUS AND METHOD OF PRODUCING THIN FILM**

(57)      A thin film of Al is unfailingly produced by feeding action gas (17) containing chlorine into chamber (1), increasing the pressure within the chamber (1) to thereby prolong the staying period thereof, causing chloride radicals to etch an etching object member (11) containing Al so as to form precursor $AlCl_3$ composed of halogen Cl and the Al component of the etching object member, and causing the Al component of the precursor $AlCl_3$ to, via, easily reducible by chloride radicals, $AlCl_2$ and $AlCl$ intermediates, form a film on the side of substrate (3).

*FIG. 1*

**Description**

**TECHNICAL FIELD**

The present invention relates to a thin-film producing apparatus which can form a film of an Al component, and to a method of producing a thin film.

**BACKGROUND ART**

At present, in a field of manufacturing a semiconductor or the like, a film-forming method with the use of a plasma CVD (Chemical Vapor Deposition) apparatus is known. The plasma CVD apparatus is an apparatus for depositing a metal thin film or the like, by converting a gas of an organometallic complex or the like which is a material of the film and has been introduced in a chamber, into a plasma state by using a high-frequency wave that is incident from a high-frequency antenna, and by promoting a chemical reaction on the surface of a substrate by an active excited atom in the plasma.

In contrast, the present inventors developed a plasma CVD apparatus (hereinafter referred to as a new type of plasma CVD apparatus) and a film-forming method (see following Patent Document 1, for instance), which are followed. In the plasma CVD apparatus and the film-forming method, an etching object member made from a metal component that forms a high-vapor-pressure halide, and is expected to form a film, is provided in a chamber, a halogen gas converted into a plasma state to etch above described etching object member by the radical of halogen, thereby generating a precursor of a halide of the metal component, and simultaneously only the metal component of the precursor deposit on the substrate.

The above described new type of the plasma CVD apparatus is structured so as to form the metal film on the substrate by controlling the temperature of the substrate to be lower than that of the etching object member to be a source of a metal to be deposited, at a predetermined low pressure (0.1 Torr to 0.2 Torr, for instance). For instance, when the metal of the etching object member is represented by M, and a halogen gas is represented by $Cl_2$, a thin film of M can be formed on the above described substrate by controlling the etching object member to a high temperature (300°C to 700°C, for instance), and controlling the substrate to a low temperature (approximately 200°C, for instance). This process is considered to be caused by the following reactions.

(1) dissociation reaction of plasma; $Cl_2 \rightarrow 2Cl^*$
(2) etching reaction; $M + Cl^* \rightarrow MCl\ (g)$
(3) adsorption reaction onto substrate; $MCl\ (g) \rightarrow MCl\ (ad)$
(4) deposition reaction; $MCl\ (ad) + Cl^* \rightarrow M + Cl_2 \uparrow$

Here, $Cl^*$ represents a radical of Cl, (g) represents a gas state, and (ad) represents an adsorbed state respectively.

The above described new type of the CVD apparatus appropriately keeps a ratio of MCl to $Cl^*$ to make a deposition reaction appropriately proceed. Specifically, a flow rate of $Cl_2$ gas, a pressure, a power, temperatures of the substrate and the etching object member, a distance between the substrate and the etching object member, and the like as film-forming conditions are appropriately set, and thereby the ratio of MCl and $Cl^*$ can be controlled to be approximately the same, and M is detected without lowering a film-forming speed, and besides, without making $Cl^*$ excessively etch the substrate.

When a thin film of Al is formed in the above described new type of the CVD apparatus, MCl in the reaction formula is $AlX_3$. $AlX_3$ is stable, so that it is difficult to cause an etching (reducing) reaction due to $Cl^*$, under present circumstances. $AlX_3$ also has a lower sublimation temperature than 200°C, so that it is considered that $AlX_3$ in an absorbed state evaporates in the film-forming reaction, which makes it difficult to form a film unless the temperature is accurately controlled. From such a situation, such a technology has not been established as to unfailingly produce a thin film of Al in the new type of the CVD apparatus.

Patent Document 1: Japanese Patent Application Laid-Open No. 2003-147534

**DISCLOSURE OF THE INVENTION**

The present invention is designed with respect to the above described circumstances, and the object is to provide a thin-film producing apparatus and a method of producing the thin film which can unfailingly produce a thin film of AlN with the use of a new type of a CVD apparatus.

In order to achieve the above described object, a thin-film producing apparatus of the present invention according to claim 1 is a thin-film producing apparatus comprising: a chamber configured to accommodate a substrate therein; an etching object member containing Al configured to provide at a position opposing to the substrate in the chamber; action gas feeding means for feeding an action gas containing a halogen into the inside of the chamber; a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical; and a controlling means for depositing an Al component of the precursor $AlX_3$ on the substrate side through intermediate products of $AlX_2$ and AlX by lowering temperature of the substrate side less than temperature of the etching object member and simultaneously controlling the staying period of fluid.

Thus, the thin-film producing apparatus controls the staying period of the fluid to form the intermediate products of $AlX_2$ and AlX, makes the Al component of the precursor $AlX_3$ form its film on the substrate side through the intermediate product, accordingly facilitates a reduction by the halogen radical, and can unfailingly produce a thin film of Al.

In order to achieve the above described object, a thin-film producing apparatus of the present invention according to claim 2 is a thin-film producing apparatus comprising: a chamber configured to accommodate a substrate therein; an etching object member containing Al configured to provide at a position opposing to the substrate in the chamber; action gas feeding means for feeding an action gas containing a halogen into the inside of the chamber; a plasma generating means for generating a plasma of the action gas by generating plasma within the chamber to generate a halogen radical, and generating a precursor $AlX_2$ formed by Al component contained in the etching object member and halogen X by controlling a staying period of a fluid to etch the etching object member with the halogen radical; and a controlling means for depositing an Al component of the precursor $AlX_2$ on the substrate side through intermediate products of AlX by lowering temperature of the substrate side less than temperature of the etching object member and simultaneously controlling the staying period of fluid.

Thus, the thin-film producing apparatus controls the staying period of the fluid to make halogen components of $AlX_2$ react with each other and make the Al component form its film on the substrate side, and accordingly can unfailingly produce a thin film of the Al component of the precursor $AlX_2$. In this case, the thin-film producing apparatus can generate the intermediate product of AlX from the precursor $AlX_2$, and make the Al component of the precursor $AlX_2$ form its film on the substrate side through the intermediate product.

In order to achieve the above described object, a thin-film producing apparatus of the present invention according to claim 3 is a thin-film producing apparatus comprising: a chamber configured to accommodate a substrate therein; an etching object member containing Al configured to provide at a position opposing to the substrate in the chamber; action gas feeding means for feeding an action gas containing a halogen into the inside of the chamber; a plasma generating means for generating a plasma of the action gas by generating plasma within the chamber to generate a halogen radical, and generating a precursor AlX formed by Al component contained in the etching object member and halogen X by controlling a staying period of a fluid to etch the etching object member with the halogen radical; and a controlling means for depositing an Al component of the precursor AlX on the substrate side by lowering temperature of the substrate side less than temperature of the etching object member and simultaneously controlling the staying period of fluid.

Thus, the thin-film producing apparatus controls the staying period of the fluid to form a precursor AlX, makes the precursor AlX react with a halogen radical to make the Al component form its film on the substrate side, and accordingly can unfailingly produce a thin film of Al.

The thin-film producing apparatus of the present invention according to claim 4 is **characterized in that** the staying period is derived from a value calculated by dividing the volume of the chamber by a product of a flow rate of the action gas, a temperature in the atmosphere and a pressure in the chamber, and the plasma generating means and the control means control the staying period by adjusting the pressure in the chamber to deposit the Al component of the precursor $AlX_3$ on the substrate side through the intermediate products of $AlX_2$ and AlX, in the thin-film producing apparatus according to claim 1.

Thus, the thin-film producing apparatus adjusts the pressure in the chamber, and thereby can form the film of the Al component of the precursor $AlX_3$ on the substrate side.

The thin-film producing apparatus of the present invention according to claim 5 is **characterized in that** the staying period is derived from a value calculated by dividing the volume of the chamber by a product of a flow rate of the action gas, a temperature in the atmosphere and a pressure in the chamber, and the plasma generating means and the control means control the staying period by adjusting the pressure in the chamber to a higher pressure than a pressure at which the intermediate products of $AlX_2$ and AlX are formed, to deposit the Al component of the precursor $AlX_2$ on the substrate side through the intermediate product of AlX, in the thin-film producing apparatus according to claim 2.

Thus, the thin-film producing apparatus can form the film of the Al component of the precursor $AlX_2$ on the substrate side by adjusting the pressure in the chamber to the higher pressure than the pressure in which the intermediate products of $AlX_2$ and AlX are formed.

The thin-film producing apparatus of the present invention according to claim 6 is **characterized in that** the staying period is derived from a value calculated by dividing the volume of the chamber by a product of a flow rate of the action gas, a temperature in the atmosphere and a pressure in the chamber, and the plasma generating means and the control means control the staying period by adjusting the pressure in the chamber to a higher pressure than a pressure at which an intermediate product of AlX is formed, to deposit the Al component of the precursor AlX on the substrate side, in the thin-film producing apparatus according to claim 3.

Thus, the thin-film producing apparatus can form the film of the Al component of the precursor AlX on the substrate side by adjusting the pressure in the chamber to the higher pressure than the pressure in which the intermediate product of AlX is formed.

The thin-film producing apparatus of the present invention according to claim 7 is **characterized in that** the thin-film producing apparatus according to claim 4 further comprises halogen-radical-density increasing means for increasing the density of a halogen radical by increasing a plasma power when the pressure in the chamber is adjusted in order to control the staying period.

Thus, the density of the halogen radical is increased even if the pressure is increased, and accordingly the balance of the halogen radical can be kept.

The thin-film producing apparatus of the present invention according to claim 8 is **characterized in that** the thin-film producing apparatus according to claim 4 further comprises halogen-radical feeding means for feeding a halogen radical into the chamber when the pressure in the chamber is adjusted in order to control the staying period.

Thus, the halogen radical is fed even if the pressure is increased, and accordingly the balance of the halogen radical can be kept.

The thin-film producing apparatus of the present invention according to claim 9 is **characterized in that** the thin-film producing apparatus according to claim 1 further comprises argon-adding means for adding argon in order to lower an electron temperature when the film of the Al component is formed on the substrate side.

Thus, the thin-film producing apparatus can lower the temperature of the substrate on which the film of the Al component has been formed on the substrate side by lowering the electron temperature by adding argon, thereby inhibits halogen from etching Al, and can increase a film-forming speed.

The thin-film producing apparatus of the present invention according to claim 10 is **characterized in that** the halogen contained in the action gas is chlorine, in the thin-film producing apparatus according to claim 1.

Thus, inexpensive chlorine can be used.

In order to achieve the above described object, a method of producing a thin film of the present invention according to claim 11 is a method of producing a thin film comprising: feeding an action gas containing a halogen into a chamber; controlling a staying period of a fluid to etch an etching object member containing Al with a halogen radical to form a precursor $AlX_3$ formed by an Al component contained in the etching object member and the halogen X; and depositing the Al component of the precursor $AlX_3$ on a substrate side through intermediate products of $AlX_2$ and AlX.

Thus, the method of producing the thin film controls the staying period of the fluid to form the intermediate products of $AlX_2$ and AlX, makes the Al component of the precursor $AlX_3$ form its film on the substrate side through the intermediate products, accordingly facilitates a reduction by the halogen radical, and can unfailingly produce the thin film of Al.

In order to achieve the above described object, a method of producing a thin film of the present invention according to claim 12 is a method of producing a thin film comprising: feeding an action gas containing a halogen into a chamber; controlling a staying period of a fluid to etch an etching object member containing Al with a halogen radical to form a precursor $AlX_2$ formed by an Al component contained in the etching object member and the halogen X; and depositing the Al component of the precursor $AlX_2$ on a substrate side.

Thus, the method of producing the thin film controls the staying period of the fluid to form the Al component of $AlX_2$ on the substrate side, and accordingly can unfailingly produce the thin film of Al.

In order to achieve the above described object, a method of producing a thin film of the present invention according to claim 13 is a method of producing a thin film comprising: feeding an action gas containing a halogen into a chamber; controlling a staying period of a fluid to etch an etching object member containing Al with a halogen radical to form a precursor AlX formed by an Al component contained in the etching object member and the halogen X; and depositing the Al component of the precursor AlX on a substrate side.

Thus, the method of producing the thin film controls the staying period of the fluid to make AlX react with the halogen radical and make the Al component form its film on the substrate side, and accordingly can unfailingly produce the thin film of Al.

The method of producing the thin film of the present invention according to claim 14 is **characterized in that** in the method of producing the thin film according to claim 11, the staying period of the fluid is prolonged by increasing a pressure in the chamber, and Al component of the precursor $AlX_3$ is deposited on the substrate side through the intermediate products of $AlX_2$ and AlX.

Thus, the method of producing the thin film adjusts the pressure in the chamber, and thereby can form the film of the Al component of the precursor $AlX_3$ on the substrate side.

The method of producing the thin film of the present invention according to claim 15 is **characterized in that** in the method of producing the thin film according to claim 12, the staying period of the fluid is prolonged by controlling the pressure in the chamber so as to be higher than a pressure at which $AlX_2$ and $AlX$ are formed, and the Al component of the precursor $AlX_2$ is deposited on the substrate side through an intermediate product of $AlX$.

Thus, the method of producing the thin film adjusts the pressure in the chamber to the higher pressure than the pressure at which the intermediate products of $AlX_2$ and $AlX$ are formed, and thereby can make the Al component of the precursor $AlX_2$ form its film on the substrate side.

The method of producing the thin film of the present invention according to claim 16 is **characterized in that** in the method of producing the thin film according to claim 13, the staying period of the fluid is prolonged by controlling the pressure in the chamber so as to be higher than a pressure at which $AlX$ is formed, and the Al component of the precursor $AlX$ is deposited on the substrate side.

Thus, the method of producing the thin film adjusts the pressure in the chamber to the higher pressure than the pressure at which the intermediate product of $AlX$ is formed, and can make the Al component of the precursor $AlX$ form its film on the substrate side.

The method of producing the thin film of the present invention according to claim 17 is characterized in that the halogen contained in the action gas is chlorine in the method of producing the thin film according to claim 11.

Thus, inexpensive chlorine can be used.

A thin-film producing apparatus according to the present invention is a thin-film producing apparatus which can unfailingly produce a thin film of Al by using a new type of a CVD apparatus.

In addition, a method of producing a thin film according to the present invention is the method of producing the thin film, which can unfailingly produce the thin film of Al by using the new type of the CVD apparatus.

## BRIEF DESCRIPTION OF THE DRAWINGS

FIG. 1 is a schematic side view of a thin-film producing apparatus according to one embodiment of the present invention;
FIG. 2 is a graph showing a light-emitting state of plasma;
FIG. 3 is a graph showing a relationship among a pressure, a precursor and a chlorine radical;
FIG. 4 is a graph showing a relationship among a plasma density, a precursor and a chlorine radical;
FIG. 5 is a schematic side view of a thin-film producing apparatus according to another embodiment of the present invention; and
FIG. 6 is a graph showing a relationship between a state of plasma and a state of a fluid in a chamber with time.

## BEST MODES FOR CARRYING OUT THE INVENTION

Embodiments according to the present invention will now be described in detail below with reference to the drawings.

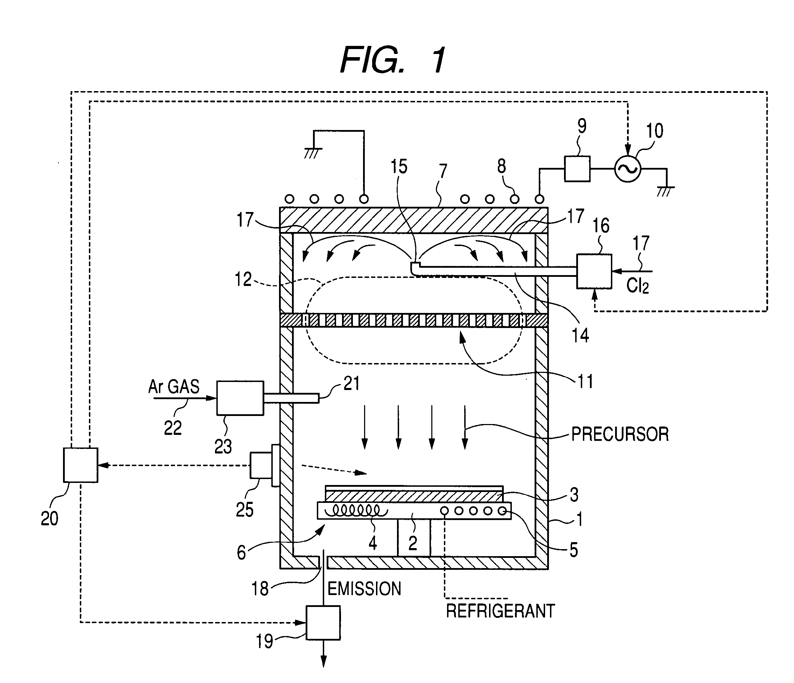

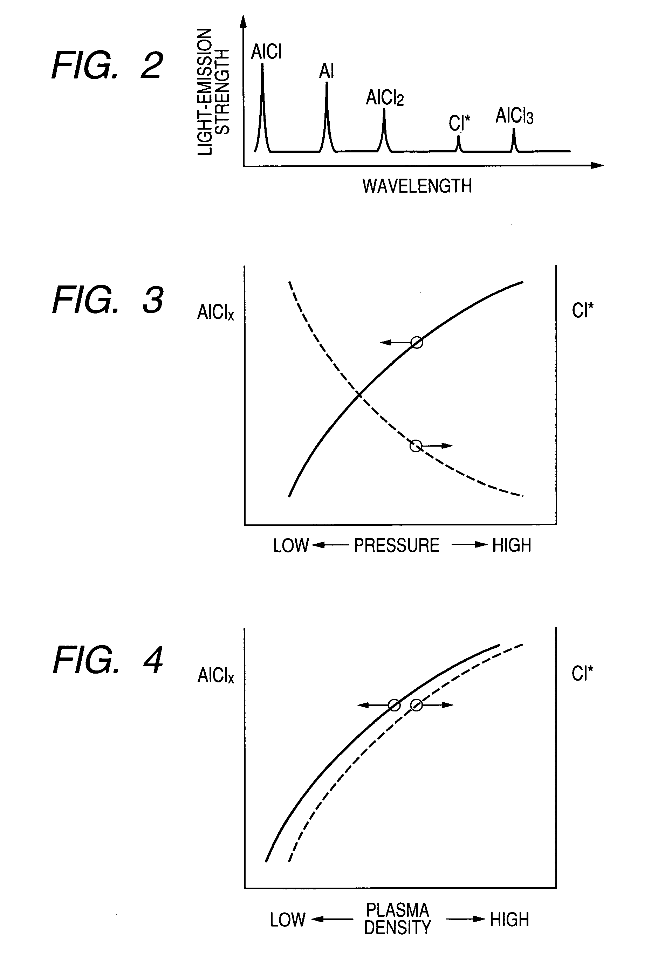

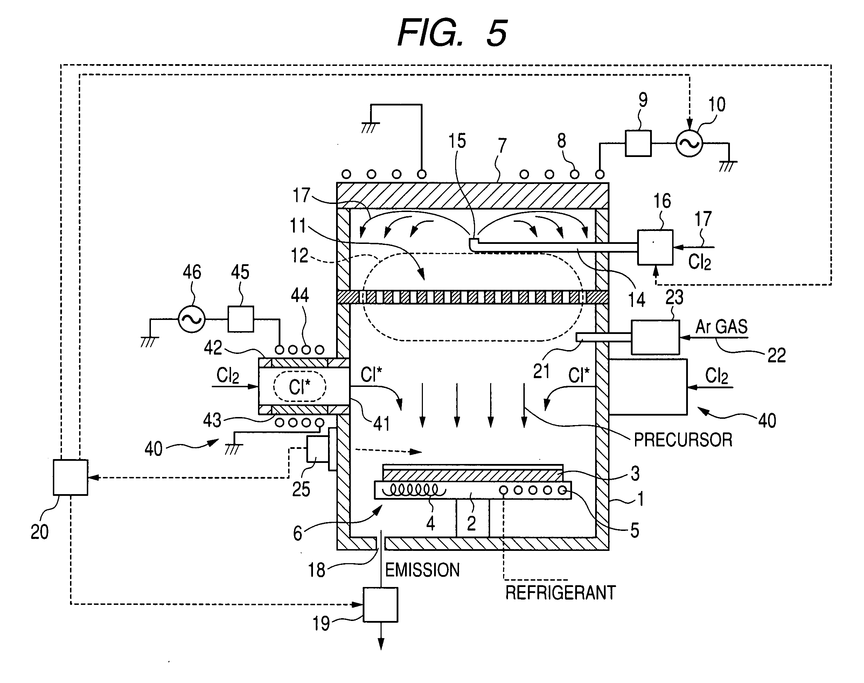

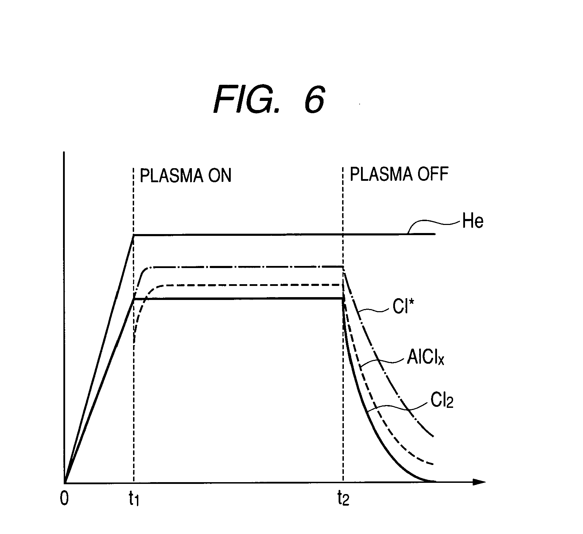

FIG. 1 illustrates a schematic side view of a thin-film producing apparatus according to one embodiment of the present invention; FIG. 2 shows a graph showing a light-emitting state of plasma; FIG. 3 shows a graph showing a relationship among a pressure, a precursor and a chlorine radical; FIG. 4 shows a graph showing a relationship among a plasma density, a precursor and a chlorine radical; FIG. 5 illustrates a schematic side view of a thin-film producing apparatus according to another embodiment of the present invention; and FIG. 6 shows a graph showing a relationship between a state of plasma and a state of a fluid in a chamber with time.

As is illustrated in FIG. 1, a support table 2 is provided in the vicinity of the bottom part of a chamber 1, for instance, made from a ceramic (made from insulation material), which has been formed to be a cylindrical shape, and a substrate 3 is mounted on the support table 2. Temperature control means 6 which includes a heater 4 and refrigerant circulating means 5 is provided on the support table 2, and the support table 2 is controlled to a predetermined temperature (such temperature that substrate 3 is kept at 100°C to 300°C, for instance) by the temperature control means 6. Incidentally, the shape of the chamber is not limited to the cylindrical shape, but the chamber can employ, for instance, a rectangular shape as well.

The upper face of the chamber 1 is formed to be an opening portion, and the opening portion is blocked with a tabular ceiling board 7 made from an insulation material (made from ceramic, for instance). A plasma antenna 8 for forming a plasma state in the inside of the chamber 1 is provided above the ceiling board 7, and the plasma antenna 8 is formed to be a planar ring shape parallel to the plane of the ceiling board 7. A matching box 9 and a power source 10 are connected to the plasma antenna 8, and feed a high-frequency power thereto. Plasma generating means for generating an induction plasma is constituted by the plasma antenna 8, the matching box 9 and the power source 10.

An etching object member (member to be etched) 11 made from aluminum (Al) is held by the chamber 1, and is arranged in between the substrate 3 and the ceiling board 7 in a discontinuous state with respect to an electric flow of the plasma antenna 8. The etching object member 11 is formed, for instance, to be a grid shape and in a structurally discontinuous state with respect to the peripheral direction which is the direction of the electric flow of the plasma antenna 8.

As for a configuration of the etching object member which is set at a discontinuous state with respect to the electric flow of the plasma antenna 8, it is also possible to form the etching object member into a mesh shape, or to form a plurality of long protrusions in the inner peripheral side of the ring.

One line of a gas nozzle 14 for feeding an action gas 17 containing chlorine as a halogen (gas: $Cl_2$ gas diluted to predetermined concentration by He) into the inner part of the chamber 1 is provided in a cylinder portion of the chamber 1 above the etching object member 11. The gas nozzle 14 extends to the central part of the chamber 1, and the tip is directed toward the upside and is made to be a gas blow hole 15. Gases of He and $Cl_2$ are individually controlled and sent to a flow rate controller 16, and $Cl_2$ gas 17 which has been diluted by He is sent to the gas nozzle 14 through the flow rate controller 16 which controls the flow rate and the pressure (action gas feeding means).

The shape and the arrangement of the gas nozzle 14 is not limited to the illustrated example, but for instance, a plurality of gas nozzles may be connected in the peripheral direction of the chamber 1 at equal spaces (on eight spots, for instance). Fluorine, bromine, iodine or the like can be applied to the halogen contained in the action gas. By using chlorine as the halogen, the thin film can be produced with the use of inexpensive chlorine gas.

In addition, a nozzle 21 functioning as argon-adding means which appropriately feeds Ar gas in the vicinity of the surface of the substrate 3 when a desired film formation has been finished is provided in the cylinder portion of the chamber 1. Ar gas 22 is fed into the chamber 1 from the nozzle 21 through a flow rate controller 23, and by generating plasma, the electron temperature in the vicinity of the substrate 3 is lowered to decrease the radiant energy of the surface of the substrate. Thus, the temperature of the substrate 3 can be lowered, and it is possible to inhibit the produced thin film from being etched by a Cl radical which will be described later.

A gas which does not participate in a film-forming process is emitted (exhausted) from a vent 18. The inside of the chamber 1 which has been sealed with the ceiling board 7 is kept at a predetermined pressure by a vacuum unit 19. An unshown valve of the vacuum unit 19 is controlled by control means 20, and the inside of the chamber is controlled to a desired pressure through adjustment by the valve.

On the other hand, the control means 20 appropriately adjusts the output of the power source 10, and consequently can control an RF power. In addition, the control means 20 switches the power source to an OFF state from an ON state according to a film-forming state over time and appropriately controls the generation of plasma in the chamber 1. The control means 20 also controls the flowing state of the gas in the flow rate controllers 16 and 23 in synchronization with the ON/OFF control for the power source.

A plasma spectroscope 25 for detecting a light-emitting state of plasma (light-emission strength with respect to wavelength, for instance) is provided in the cylinder portion of the chamber 1, determines the states (spectroscopic data) of a Cl radical, $AlX_3$, $AlX_2$ and AlX, which will be described later, based on the spectroscopic data, and sends the spectroscopic data to the control means 20.

The above described thin-film producing apparatus feeds an action gas 17 containing chlorine into the chamber 1, controls (prolongs) the staying period of the fluid, specifically, increases the pressure in the chamber 1, makes the chlorine radical etch the etching object member containing Al 11 to form a precursor $AlCl_3$ formed by an Al component contained in the etching object member and halogen Cl, and makes the Al component of the precursor $AlCl_3$ form its film on the substrate 3 side through intermediate products of $AlCl_2$ and AlCl.

The intermediate products of $AlCl_2$ and AlCl are formed by prolonging the staying period of the fluid, and the Al component of the precursor $AlX_3$ is deposited on the substrate 3 side through the intermediate products. Accordingly a reduction by the Cl radical can be facilitated, and a thin film of Al can be unfailingly produced.

Here, the staying period of the fluid is controlled by increasing the pressure in the chamber 1. The staying period (t) of the fluid is expressed by

$$t=V/QTP.$$

Here, Q represents a flow rate of gas, T represents a temperature in the atmosphere, P represents a pressure {760 (Torr) /P (Total)}, and V represents a volume in the reaction atmosphere. Accordingly, prolonging the staying period of the fluid, by which the intermediate products of $AlCl_2$ and AlCl is formed, can be attained by any of operations of: raising the pressure P (Total: Torr) to decrease the P to a small value; reducing the flow rate; lowering the temperature; and increasing the volume. In the present embodiment, in consideration of the controllability or the like, the staying period is prolonged by raising the pressure P (Total: Torr).

When a metal thin film is produced by using a new type of a CVD apparatus, the pressure P (Total: Torr) is set in a range of 0.1 to 0.2 (Torr), but in the present embodiment, the pressure P (Total: Torr) is set, for instance, in a range of 0.5 to 1.0 (Torr), and the staying period is set at approximately 1.5 times longer. The pressure P is set by the control of an unshown valve of the vacuum unit 19.

The specific film-forming (deposition) state will now be described below.

$Cl_2$ gas 17 is fed to the inner part of the chamber 1, which has been controlled to 0.5 to 1.0 (Torr), from a gas nozzle 14. A plasma antenna 8 projects an electromagnetic wave to the inside of the chamber 1, ionizes the $Cl_2$ gas 17 to generate a plasma of the $Cl_2$ gas, and forms Cl radicals. The plasma is generated in a region illustrated by gas plasma 12. The reaction at this time can be expressed by the following formula:

$$Cl_2 \rightarrow 2Cl^*$$

, wherein $Cl^*$ represents a chlorine radical.

The gas plasma 12 acts on an etching object member containing Al 11 to heat the etching object member 11 and simultaneously cause an etching reaction on Al. The reaction at this time can be expressed, for instance, by the following formula.

$$AlCl_3 \rightarrow AlCl_2 \rightarrow AlCl$$

The chlorine radical $Cl^*$ acts on $AlCl_3$, thereby causes the reaction of:

$$AlCl_3 + Cl^* \rightarrow AlCl_2 + Cl_2 \uparrow, \text{ and forms } AlCl_2.$$

The chlorine radical $Cl^*$ also acts on $AlCl_2$, thereby causes the reaction of:

$$AlCl_2 + Cl^* \rightarrow AlCl + Cl_2 \uparrow, \text{ and forms } AlCl.$$

Furthermore, the chlorine radical $Cl^*$ acts on AlCl, thereby causes the reaction of:

$$AlCl + Cl^* \rightarrow Al + Cl_2 \uparrow, \text{ and forms an Al component.}$$

Thus, the thin-film producing apparatus forms easily reducible intermediate products of $AlCl_2$ and AlCl, makes the Al component of the precursor $AlX_3$ form its film on the substrate 3 side through the easily reducible (unstable) intermediate products, accordingly facilitates a reduction by the Cl radical, and can unfailingly produce a thin film of Al with high controllability.

When the above described thin film of Al is produced, a plasma spectroscope 25 detects a light-emitting state of plasma (light-emission strength with respect to wavelength, for instance) in the film-forming process. Specifically, the light-emission strengths of $AlCl_3$, $AlCl_2$, AlCl, the chlorine radical $Cl^*$ and Al are different according to the wavelengths, as is illustrated in FIG. 2, and accordingly the plasma spectroscope 25 can detect the states of $AlCl_3$, $AlCl_2$, AlCl, the chlorine radical $Cl^*$ and Al by detecting the light-emission strengths.

The detected data by the plasma spectroscope 25 is sent to control means 20, and the control means 20 monitors whether $AlCl_3$, $AlCl_2$, AlCl, the chlorine radical $Cl^*$ and Al are formed in a desired state through the above described reaction process. When the desired product has not been obtained (when the state of light-emission strengths does not match with a previously memorized state) as a result of monitoring, the control means 20 commands a vacuum unit 19 to adjust an unshown valve and control the pressure so that $AlCl_3$, $AlCl_2$, AlCl, the chlorine radical $Cl^*$ and Al can be formed in the desired state.

By the way, when the pressure is raised as is illustrated in FIG. 3, a chlorine radical $Cl^*$ decreases, which may cause an unequal balance with $AlCl_x$. As is illustrated in FIG. 4, when a plasma density is increased, the chlorine radical $Cl^*$ and $AlCl_x$ increase, so that the control means 20 appropriately adjusts the output of a power source 10 to increase an RF power in synchronization with an action of raising the pressure, and thereby increases the plasma density. The operation increases the chlorine radical $Cl^*$, eliminates the possibility of decreasing the chlorine radical $Cl^*$ even when having raised the pressure, and can keep the balance with $AlCl_x$.

Incidentally, as for a configuration of increasing a chlorine radical $Cl^*$, a configuration of separately feeding the chlorine radical $Cl^*$ may be adopted other than a method of raising an RF power.

A thin-film producing apparatus having the structure of separately feeding the chlorine radical $Cl^*$ will now be described with reference to FIG. 5. The same members as those illustrated in FIG. 1 are denoted by the same reference numerals, and overlapping descriptions are omitted. The thin-film producing apparatus illustrated in FIG. 5 has radical-supplying means.

As for a radical-supplying means 40, opening parts 41 are provided in the periphery (in four spots, for instance) of a chamber 1, and one each end of a cylindrical radical passage 42 is fixed to the opening part 41. A cylindrical excitation chamber 43 made of an insulative body is provided in the middle of the radical passage 42, and a plasma antenna 44 with a coil shape is provided in the periphery of the excitation chamber 43. A matching box 45 and a power source 46 are connected to the plasma antenna 44, and an electric power is supplied thereto from the power source 46. Chlorine gas ($Cl_2$ gas) as a halogen is fed to the radical passage 42, and is excited by an electromagnetic wave which has been projected into the inner part of the excitation chamber 43 from the plasma antenna 44 to form a chlorine radical $Cl^*$ as a halogen radical. The chlorine radical $Cl^*$ which has been formed in the excitation chamber 43 is fed into the chamber 1 from the opening part 41.

When the chlorine radical $Cl^*$ may decrease by raising the pressure, the radical-supplying means 40 feeds the chlorine radical $Cl^*$ to the chamber 1. The operation increases the chlorine radical $Cl^*$, eliminates the possibility of decreasing the chlorine radical $Cl^*$ even when having raised the pressure, and can keep the balance with $AlCl_x$.

In the thin-film producing apparatus as illustrated in FIG. 1 and FIG. 5, when a thin film of Al has been produced on a substrate 3 (in the end of film formation), Ar gas 22 is fed into the chamber 1 from a nozzle 21 through a flow rate controller 23 and generates plasma. The operation lowers the electron temperature in the vicinity of the substrate 3, reduces a radiant energy of the surface of the substrate, can lower the temperature of the substrate 3, and can inhibit the produced thin film from being etched by a Cl radical $Cl^*$.

Furthermore, in the thin-film producing apparatus as illustrated in FIG. 1 and FIG. 5, when the plasma is stopped at the end of film formation, only $Cl_2$ gas is stopped and He gas (rare gas) for dilution is continuously passed. By continuously passing the He gas, the thin-film producing apparatus makes the Cl radical $Cl^*$ which remains after the plasma has been stopped react with He, and exhausts the resultant gas as $Cl_2$ gas. Thereby, the formed thin film of Al is not affected by the remaining Cl radical $Cl^*$.

The state of the fluid in the chamber 1 will now be described in detail with reference to FIG. 6.

As is illustrated in FIG. 6, when $Cl_2$ gas which has been diluted by He gas is fed from a gas nozzle 14 (see FIG. 1 and FIG. 5), He and $Cl_2$ gradually increase until t1 when the plasma is turned ON. When the plasma is turned ON at the time of t1 and simultaneously the flow rate of the gas nozzle 14 is kept constant (see FIG. 1 and FIG. 5), a Cl radical $Cl^*$ is generated and simultaneously etches an etching object member 11 (see FIG. 1 and FIG. 5), and thereby $AlCl_x$ is formed.

At the time of t2 when the thin film of Al has been produced, the plasma is turned to an OFF state, only $Cl_2$ gas is stopped and He gas (rare gas) for dilution is continuously passed. At this time, the gas is continuously emitted. After the plasma was turned to the OFF state at the time of t2, $Cl_2$, the Cl radical $Cl^*$ and $AlCl_x$ decrease gradually. The remaining Cl radical $Cl^*$ may affect the formed thin film of Al, but because He gas is fed, the remaining Cl radical $Cl^*$ reacts with He, and the resultant gas is exhausted as $Cl_2$ gas.

The reaction at this time can be expressed by the following formula.

$$Cl^* + Cl^* \rightarrow Cl_2\uparrow + He$$

The remaining Cl radical $Cl^*$ can be exhausted by continuously passing He gas (rare gas) even after the plasma has been turned to the OFF state, and the formed thin film of Al is not affected by the remaining Cl radical $Cl^*$.

Incidentally, the thin-film producing apparatus in the present embodiment is structured so as to feed a rare gas by continuously passing He gas for dilution, but can be structured so as to feed He gas when the plasma is stopped, by separately installing a nozzle therein. Ar and Xe can also be applied as the rare gas. When Ar is applied, Ar gas 22 to be supplied from the nozzle 21 can be used.

A method of producing a thin film according to another exemplary embodiment with the use of the above described thin-film producing apparatus will now be described.

The method includes feeding an action gas 17 containing chlorine into a chamber 1, controlling (prolonging) a staying period of a fluid, specifically, raising the pressure in the chamber 1, making a chlorine radical etch an etching object member containing Al 11 to form a precursor $AlCl_2$ formed by an Al component contained in the etching object member and halogen Cl, and making halogen components of $AlCl_2$ react with each other to make the Al component form its film on the substrate 3 side.

The method forms $AlCl_2$ by controlling the staying period of the fluid, makes halogen components of $AlCl_2$ react with each other to deposit the Al component on the substrate side, and can unfailingly produce a thin film of the Al component of the precursor $AlX_2$.

Similarly to the above description, the method prolongs the staying period by raising the pressure P (Total: Torr) to form an intermediate product AlX. For instance, the pressure P (Total: Torr) is set in a range of 1.0 to 2.0 (Torr) to form the intermediate product AlX. The pressure P is set by the control of an unshown valve of a vacuum unit 19.

The specific film-forming (deposition) state will now be described below with reference to FIG. 1.

$Cl_2$ gas 17 is fed to the inner part of a chamber 1, which has been controlled to 1.0 to 2.0 (Torr), from a gas nozzle 14. A plasma antenna 8 projects an electromagnetic wave to the inside of the chamber 1, ionizes the $Cl_2$ gas 17

to generate a plasma of the $Cl_2$ gas, and forms Cl radicals. The plasma is generated in a region illustrated by gas plasma 12. The reaction occurring at this time can be expressed by the following formula:

$$Cl_2 \rightarrow 2Cl^*$$

, wherein $Cl^*$ represents a chlorine radical.

The gas plasma 12 acts on an etching object member containing Al 11 to heat the etching object member 11, and simultaneously causes an etching reaction on Al to form $AlCl_2$. The formed $AlCl_2$ causes the reaction of:

$AlCl_2 + AlCl_2 \rightarrow 2Al\downarrow + 2Cl_2\uparrow$, and produces a thin film of Al. Specifically, the $Cl_2$ components of $AlCl_2$ react with each other to make the Al component form its film on a substrate side, and a thin film of the Al component of a precursor $AlX_2$ is formed.

At this time, it is possible to make a chlorine radical $Cl^*$ act on $AlCl_2$ by changing the pressure condition in the film-forming process, to cause the reaction of:

$AlCl_2 + Cl^* \rightarrow AlCl + Cl_2\uparrow$, and to form AlCl. It is also possible to make the chlorine radical $Cl^*$ act on AlCl, to cause the reaction of:

$AlCl + Cl^* \rightarrow Al + Cl_2\uparrow$, and to form the Al component.

Thereby, the method forms unstable $AlCl_2$, deposits the Al component of $AlCl_2$ on a substrate 3 side, and accordingly can unfailingly produce a thin film of Al having high film quality.

When the above described thin film of Al is produced, a plasma spectroscope 25 detects a light-emitting state of plasma (light-emission strength with respect to wavelength, for instance) in the film-forming process. Specifically, the light-emission strengths of $AlCl_2$, AlCl, the chlorine radical $Cl^*$ and Al are different according to the wavelengths, and accordingly the plasma spectroscope 25 can detect the states of $AlCl_2$, AlCl, the chlorine radical $Cl^*$ and Al by detecting the light-emission strengths.

The detected data by the plasma spectroscope 25 is sent to control means 20, and the control means 20 monitors whether $AlCl_2$, AlCl, the chlorine radical $Cl^*$ and Al are formed in a desired state through the above described reaction process. When the desired product has not been obtained (when the state of light-emission strengths does not match with a previously memorized state) as a result of monitoring, the control means 20 commands a vacuum unit 19 to adjust an unshown valve and control the pressure so that $AlCl_2$, AlCl, the chlorine radical $Cl^*$ and Al can be formed in the desired state.

In addition, it is possible to employ a process of changing the pressure condition in the process of forming $AlCl_2$ as an intermediate product from the previously described $AlCl_3$, making the $Cl_2$ components of $AlCl_2$ react with each other, and making the Al component extracted from $AlCl_2$ form its film on the substrate side.

When the film formation has been finished, the method lowers the electron temperature in the vicinity of the substrate 3 with the use of Ar gas, and reduces a radiant energy of the surface of the substrate, similarly to the above description. In addition, the remaining Cl radical $Cl^*$ is exhausted by continuously passing He gas (rare gas) even after the plasma has been turned to the OFF state so as not to affect the formed thin film of Al.

A method of producing a thin film according to still another exemplary embodiment with the use of the above described thin-film producing apparatus will now be described.

The method includes feeding an action gas 17 containing chlorine into a chamber 1, controlling (prolonging) a staying period of a fluid, specifically, raises the pressure in the chamber 1, making a chlorine radical etch an etching object member containing Al 11 to form a precursor AlCl formed by an Al component contained in the etching object member and halogen Cl, and making AlCl react with the chlorine radical to deposit the Al component on a substrate 3 side.

The method controls the staying period of the fluid to form AlCl, makes AlCl react with the chlorine radical to deposit the Al component form on the substrate side, and accordingly can unfailingly produce a thin film of the Al component in the precursor AlX.

Similarly to the above description, the method prolongs the staying period by raising the pressure P (Total: Torr) to form an intermediate product AlX. For instance, the pressure P (Total: Torr) is set in a range exceeding 2.0 (Torr) to form AlX. The pressure P is set by the control of an unshown valve of a vacuum unit 19.

The specific film-forming (deposition) state will now be described below with reference to FIG. 1.

$Cl_2$ gas 17 is fed to the inner part of a chamber 1, which has been controlled a pressure exceeding 2.0 (Torr), from a gas nozzle 14. A plasma antenna 8 projects an electromagnetic wave to the inside of the chamber 1, ionizes $Cl_2$ gas 17 to generate a plasma of the $Cl_2$ gas, and forms Cl radicals. The plasma is generated in a region illustrated by gas plasma 12. The reaction at this time can be expressed by the following formula:

$$Cl_2 \rightarrow 2Cl^*$$

, wherein $Cl^*$ represents a chlorine radical.

The gas plasma 12 acts on an etching object member containing Al 11 to heat the etching object member 11, and simultaneously causes an etching reaction on Al to form AlCl. The formed AlCl causes the reaction of:

$AlCl+Cl^* \rightarrow Al+Cl_2\uparrow$, and is converted into an Al component which produces a thin film of Al.

Thereby, the method forms unstable AlCl, deposits the Al component of AlCl on a substrate 3 side, and accordingly can unfailingly produce a thin film of Al in a short period of time.

When the above described thin film of Al is produced, a plasma spectroscope 25 detects a light-emitting state of plasma (light-emission strength with respect to wavelength, for instance) in the film-forming process. Specifically, the light-emission strengths of AlCl, a chlorine radical $Cl^*$ and Al are different according to the wavelengths, and accordingly the plasma spectroscope 25 can detect the states of AlCl, the chlorine radical $Cl^*$ and Al by detecting the light-emission strengths.

The detected data by the plasma spectroscope 25 is sent to control means 20, and the control means 20 monitors whether AlCl, the chlorine radical $Cl^*$ and Al are formed in a desired state through the above described reaction process. When the desired product has not been obtained (when the state of light-emission strengths does not match with a previously memorized state) as a result of monitoring, the control means 20 commands a vacuum unit 19 to adjust an unshown valve and control the pressure so that AlCl, the chlorine radical $Cl^*$ and Al can be formed in the desired state.

When the film formation has been finished, the method lowers the electron temperature in the vicinity of the substrate 3 with the use of Ar gas, and reduces a radiant energy of the surface of the substrate, similarly to the above description. In addition, the remaining Cl radical $Cl^*$ is exhausted so as not to affect the formed thin film of Al, by continuously passing He gas (rare gas) even after the plasma has been turned to the OFF state.

Thus, the present invention can provide a thin-film producing apparatus which can unfailingly produce a thin film of Al by using a new type of a CVD apparatus, and a method of producing the thin film therefor.

**INDUSTRIAL APPLICABILITY**

The present invention can be used in industrial applications of a thin-film producing apparatus which can form a film of an Al component, and of a method of producing the thin film.

**Claims**

1. A thin-film producing apparatus comprising:

   a chamber configured to accommodate a substrate therein;
   an etching object member containing Al configured to provide at a position opposing to the substrate in the chamber;
   action gas feeding means for feeding an action gas containing a halogen into the inside of the chamber;
   a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical; and
   a controlling means for depositing an Al component of the precursor $AlX_3$ on the substrate side through intermediate products of $AlX_2$ and AlX by lowering temperature of the substrate side less than temperature of the etching object member and simultaneously controlling the staying period of fluid.

2. A thin-film producing apparatus comprising:

   a chamber configured to accommodate a substrate therein;
   an etching object member containing Al configured to provide at a position opposing to the substrate in the chamber;
   action gas feeding means for feeding an action gas containing a halogen into the inside of the chamber;
   a plasma generating means for generating a plasma of the action gas by generating plasma within the chamber to generate a halogen radical, and generating a precursor $AlX_2$ formed by Al component contained in the etching object member and halogen X by controlling a staying period of a fluid to etch the etching object member with the halogen radical; and

a controlling means for depositing an Al component of the precursor $AlX_2$ on the substrate side through intermediate products of AlX by lowering temperature of the substrate side less than temperature of the etching object member and simultaneously controlling the staying period of fluid.

3. A thin-film producing apparatus comprising:

a chamber configured to accommodate a substrate therein;

an etching object member containing Al configured to provide at a position opposing to the substrate in the chamber;

action gas feeding means for feeding an action gas containing a halogen into the inside of the chamber;

a plasma generating means for generating a plasma of the action gas by generating plasma within the chamber to generate a halogen radical, and generating a precursor AlX formed by Al component contained in the etching object member and halogen X by controlling a staying period of a fluid to etch the etching object member with the halogen radical; and

a controlling means for depositing an Al component of the precursor AlX on the substrate side by lowering temperature of the substrate side less than temperature of the etching object member and simultaneously controlling the staying period of fluid.

4. The thin-film producing apparatus according to claim 1, wherein
the staying period is derived from a value calculated by dividing the volume of the chamber by a product of a flow rate of the action gas, a temperature in the atmosphere and a pressure in the chamber, and
the plasma generating means and the control means control the staying period by adjusting the pressure in the chamber to deposit the Al component of the precursor $AlX_3$ on the substrate side through the intermediate products of $AlX_2$ and AlX.

5. The thin-film producing apparatus according to claim 2, wherein
the staying period is derived from a value calculated by dividing the volume of the chamber by a product of a flow rate of the action gas, a temperature in the atmosphere and a pressure in the chamber, and
the plasma generating means and the control means control the staying period by adjusting the pressure in the chamber to a higher pressure than a pressure at which the intermediate products of $AlX_2$ and AlX are formed, to deposit the Al component of the precursor $AlX_2$ on the substrate side through the intermediate product of AlX.

6. The thin-film producing apparatus according to claim 3, wherein
the staying period is derived from a value calculated by dividing the volume of the chamber by a product of a flow rate of the action gas, a temperature in the atmosphere and a pressure in the chamber, and
the plasma generating means and the control means control the staying period by adjusting the pressure in the chamber to a higher pressure than a pressure at which an intermediate product of AlX is formed, to deposit the Al component of the precursor AlX on the substrate side.

7. The thin-film producing apparatus according to claim 4, further comprising halogen-radical-density increasing means for increasing the density of a halogen radical by increasing a plasma power when the pressure in the chamber is adjusted in order to control the staying period.

8. The thin-film producing apparatus according to claim 4, further comprising halogen-radical feeding means for feeding a halogen radical into the chamber when the pressure in the chamber is adjusted in order to control the staying period.

9. The thin-film producing apparatus according to claim 1, wherein further comprising argon-adding means for adding argon in order to lower an electron temperature when the film of the Al component is formed on the substrate side.

10. The thin-film producing apparatus according to claim 1, wherein
the halogen contained in the action gas is chlorine.

11. A method of producing a thin film comprising:

feeding an action gas containing a halogen into a chamber; controlling a staying period of a fluid to etch an etching object member containing Al with a halogen radical to form a precursor $AlX_3$ formed by an Al component contained in the etching object member and the halogen X; and depositing the Al component of the precursor $AlX_3$ on a substrate side through intermediate products of $AlX_2$ and AlX.

12. A method of producing a thin film comprising:

feeding an action gas containing a halogen into a chamber; controlling a staying period of a fluid to etch an etching object member containing Al with a halogen radical to form a precursor $AlX_2$ formed by an Al component contained in the etching object member and the halogen X; and depositing the Al component of the precursor $AlX_2$ on a substrate side.

13. A method of producing a thin film comprising:

feeding an action gas containing a halogen into a chamber; controlling a staying period of a fluid to etch an etching object member containing Al with a halogen radical to form a precursor AlX formed by an Al component contained in the etching object member and the halogen X; and depositing the Al component of the precursor AlX on a substrate side.

14. The method of producing the thin film according to claim 11, wherein
the staying period of the fluid is prolonged by increasing a pressure in the chamber, and Al component of the precursor $AlX_3$ is deposited on the substrate side through the intermediate products of $AlX_2$ and AlX.

15. The method of producing the thin film according to claim 12, wherein
the staying period of the fluid is prolonged by controlling the pressure in the chamber so as to be higher than a pressure at which $AlX_2$ and AlX are formed, and the Al component of the precursor $AlX_2$ is deposited on the substrate side through an intermediate product of AlX.

16. The method of producing the thin film according to claim 13, wherein
the staying period of the fluid is prolonged by controlling the pressure in the chamber so as to be higher than a pressure at which AlX is formed, and the Al component of the precursor AlX is deposited on the substrate side.

17. The method of producing the thin film according to claim 11, wherein
the halogen contained in the action gas is chlorine.

FIG. 1

EP 2 166 129 A1

FIG. 2

LIGHT-EMISSION STRENGTH

AlCl

Al

AlCl$_2$

Cl*

AlCl$_3$

WAVELENGTH

FIG. 3

AlCl$_x$

Cl*

LOW ◄── PRESSURE ──► HIGH

FIG. 4

AlCl$_x$

Cl*

LOW ◄── PLASMA DENSITY ──► HIGH

## FIG. 5

EP 2 166 129 A1

# FIG. 6

## INTERNATIONAL SEARCH REPORT

| International application No. |
| --- |
| PCT/JP2006/317442 |

A. CLASSIFICATION OF SUBJECT MATTER
*C23C16/20*(2006.01)i, *C23C16/44*(2006.01)i

According to International Patent Classification (IPC) or to both national classification and IPC

B. FIELDS SEARCHED

Minimum documentation searched (classification system followed by classification symbols)
C23C16/00-16/56

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2003-152059 A (Mitsubishi Heavy Industries, Ltd.), 23 May, 2003 (23.05.03), Par. Nos. [0020] to [0027] (Family: none) | 1-17 |
| Y | JP 2003-119565 A (Mitsubishi Heavy Industries, Ltd.), 23 April, 2003 (23.04.03), Par. Nos. [0032] to [0034] & US 2003/0031791 A1 & EP 1284305 A3 | 1-17 |
| Y | JP 2003-328128 A (Mitsubishi Heavy Industries, Ltd.), 19 November, 2003 (19.11.03), Par. Nos. [0012], [0025] & US 2004/0029384 A1 & EP 1344842 A2 | 7,8 |

☐ Further documents are listed in the continuation of Box C. ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 11 October, 2006 (11.10.06) | 24 October, 2006 (24.10.06) |

| Name and mailing address of the ISA/<br>Japanese Patent Office | Authorized officer |
| --- | --- |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003147534 A